# FASCICULE DE BREVET EUROPEEN

(11) **EP 3 144 983 B1**
(45) Date de publication et mention de la délivrance du brevet: **28.03.2018**
(21) Numéro de dépôt: 16189528.9
(22) Date de dépôt: 19.09.2016
(51) Int. Cl.: H01L 33/06, H01L 33/24, H01L 33/30

(54) **DISPOSITIF ÉLECTROLUMINESCENT À PUITS QUANTIQUES MULTIPLES**
ELEKTROLUMINESZENZVORRICHTUNG MIT MEHRFACHQUANTENTOPF-STRUKTUR
ELECTROLUMINESCENT DEVICE WITH MULTIPLE QUANTUM WELLS

(30) Priorité: 21.09.2015 FR 1558865
(43) Date de publication de la demande: 22.03.2017
(73) Titulaire: COMMISSARIAT À L'ÉNERGIE ATOMIQUE ET AUX ÉNERGIES ALTERNATIVES, 75015 Paris (FR)
(72) Inventeur: ROBIN, Ivan-Christophe, 38000 GRENOBLE (FR); DUSSAIGNE, Amélie, 38260 SAINT HILAIRE DE LA COTE (FR); FERRET, Pierre, 38000 GRENOBLE (FR)
(74) Mandataire: Thibon, Laurent

(56) Documents cités:
- US-A1- 2014 264 260

## Description

### Domaine

La présente invention concerne de façon générale les dispositifs électroluminescents à base de matériaux semiconducteurs et leurs procédés de fabrication. Par dispositifs électroluminescents, on entend des dispositifs adaptés à effectuer la conversion d'un signal électrique en un rayonnement électromagnétique.

### Exposé de l'art antérieur

Un dispositif électroluminescent comprend généralement une couche "active" qui est la couche depuis laquelle est émise la majorité du rayonnement fourni par le dispositif. La zone active peut comporter des moyens de confinement correspondant à des puits quantiques multiples. Elle comprend alors une alternance de couches semiconductrices d'un premier matériau et de couches semiconductrices d'un second matériau, chaque couche du premier matériau semiconducteur étant prise en sandwich entre deux couches du deuxième matériau semiconducteur, le premier matériau semiconducteur ayant une bande interdite inférieure à celle du deuxième matériau semiconducteur.

Il existe des dispositifs électroluminescents à structure bidimensionnelle qui sont réalisés par un empilement de couches semiconductrices sensiblement planes. Par ailleurs, il existe des dispositifs électroluminescents à structure tridimensionnelle, notamment de type radiale, comprenant des éléments semiconducteurs tridimensionnels et pour lesquels la zone active est formée à la périphérie de chaque élément tridimensionnel.

L'efficacité quantique interne de la zone active est égale au rapport entre le nombre de photons créés dans la zone active et le nombre de porteurs traversant la zone active. L'efficacité quantique interne est un nombre sans unité qui varie entre 0 et 1.

Pour une zone active à puits quantiques ayant la même composition, l'efficacité quantique interne de la zone active d'un dispositif électroluminescent à structure tridimensionnelle de type radiale est inférieure à l'efficacité quantique interne de la zone active d'un dispositif électroluminescent à structure bidimensionnelle. Le document US 2014/0264260 Al divulgue un dispositif électroluminescent comprenant des zones actives formées sur des colonnes verticales et dans une partie de la zone active, la concentration en indium diminue en se rapprochant du substrat.

### Résumé

Ainsi, un objet d'un mode de réalisation est de pallier au moins en partie les inconvénients des dispositifs électroluminescents à structure tridimensionnelle de type radiale décrits précédemment et de leurs procédés de fabrication.

Un autre objet d'un mode de réalisation est d'augmenter le rendement quantique interne de la zone active du dispositif électroluminescent.

Un autre objet d'un mode de réalisation est que la zone active du dispositif électroluminescent comprend un empilement de couches de matériaux semiconducteurs à base de composés III-V ou II-VI.

Ainsi, un mode de réalisation prévoit un dispositif électroluminescent comprenant :
un substrat ;
des éléments semiconducteurs tridimensionnels reposant sur le substrat ;
pour chaque élément semiconducteur, au moins une coque recouvrant au moins partiellement les parois latérales de l'élément semiconducteur, la coque comprenant une zone active ayant des puits quantiques multiples ; et
une électrode recouvrant au moins partiellement la coque, au moins une partie de la zone active étant prise en sandwich entre l'électrode et les parois latérales de l'élément semiconducteur,
dans lequel la zone active comprend une alternance de premières couches semiconductrices comprenant majoritairement un premier élément et un deuxième élément et de deuxièmes couches semiconductrices comprenant majoritairement le premier élément et le deuxième élément et comprenant, en outre, un troisième élément et dans lequel, dans au moins trois des deuxièmes couches, la concentration massique du troisième élément augmente dans ladite partie de la zone active en se rapprochant du substrat.

Selon un mode de réalisation, l'augmentation de la concentration massique du troisième élément est comprise entre 0,1 point de pourcentage et 9 points de pourcentage.

Selon un mode de réalisation, dans chacune desdites trois deuxièmes couches, dans n'importe quelle portion de la deuxième couche dont la hauteur est égale à 10 % de la hauteur de ladite partie de la zone active mesurée selon une direction perpendiculaire à une face du substrat, la variation de la concentration massique du troisième élément entre les extrémités, selon ladite direction, de cette portion est inférieure à 50 % de la variation de la concentration massique du troisième élément entre les extrémités, selon ladite direction, de ladite partie de la zone active.

Selon un mode de réalisation, l'augmentation de la concentration massique du troisième élément est linéaire.

Selon un mode de réalisation, chaque première couche comprend majoritairement un composé binaire III-V et chaque deuxième couche comprenant le composé III-V dans lequel l'élément de type III est en partie substitué par le troisième élément.

Selon un mode de réalisation, la concentration massique moyenne dudit troisième élément dans les deuxièmes couches est comprise entre 6 % et 25 %.

Selon un mode de réalisation, pour au moins l'un des éléments semiconducteurs, l'électrode recouvre seulement partiellement la coque recouvrant ledit élément semiconducteur.

Selon un mode de réalisation, pour au moins l'un des éléments semiconducteurs, le diamètre moyen extérieur de la zone active augmente en s'éloignant du substrat.

Selon un mode de réalisation, les éléments semiconducteurs sont des nanofils, des microfils et/ou des structures pyramidales de taille nanométrique ou micrométrique.

Un mode de réalisation prévoit également un procédé de fabrication d'un dispositif électroluminescent comprenant les étapes suivantes :
former des éléments semiconducteurs tridimensionnels reposant sur un substrat ;
former, pour chaque élément semiconducteur, au moins une coque recouvrant au moins partiellement les parois latérales de l'élément semiconducteur, la coque comprenant une zone active ayant des puits quantiques multiples ; et
former une électrode recouvrant au moins partiellement la coque, au moins une partie de la zone active étant prise en sandwich entre l'électrode et les parois latérales de l'élément semiconducteur,
dans lequel la zone active comprend une alternance de premières couches semiconductrices comprenant majoritairement un premier élément et un deuxième élément et de deuxièmes couches semiconductrices comprenant majoritairement le premier élément et le deuxième élément et comprenant, en outre, un troisième élément et dans lequel, dans au moins trois des deuxièmes couches, la concentration massique du troisième élément augmente dans ladite partie de la zone active en se rapprochant du substrat.

Selon un mode de réalisation, le procédé comprend, pour au moins l'un des éléments semiconducteurs, lors de la formation desdites au moins trois deuxièmes couches, le maintien d'un gradient de température entre l'extrémité de l'élément semiconducteur la plus éloignée du substrat et l'extrémité de l'élément semiconducteur la plus proche du substrat.

Selon un mode de réalisation, le procédé comprend, pour au moins l'un des éléments semiconducteurs, avant la formation desdites au moins trois deuxièmes couches, la formation de l'élément semiconducteur ou d'une couche recouvrant l'élément semiconducteur ayant un diamètre moyen externe plus important à l'extrémité de l'élément semiconducteur la plus éloignée du substrat qu'à l'extrémité de l'élément semiconducteur la plus proche du substrat.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe, partielle et schématique, d'un exemple d'un dispositif électroluminescent à structure bidimensionnelle ;
la figure 2 est une vue agrandie, partielle et schématique, d'une partie de la figure 1 ;
la figure 3 est une vue en coupe, partielle et schématique, d'un mode de réalisation d'un dispositif électroluminescent à structure tridimensionnelle de type radiale ;
la figure 4 est une vue agrandie, partielle et schématique, d'une partie de la figure 3 ;
les figures 5 et 6 représentent des courbes d'évolution de l'efficacité quantique interne de la zone active des dispositifs électroluminescents représentés respectivement en figure 1 et en figure 3 en fonction de la densité surfacique du courant d'alimentation du dispositif ;
les figures 7 à 11 représentent des courbes d'évolution de l'efficacité quantique interne de la zone active du dispositif électroluminescent représenté en figure 3 en fonction de la densité surfacique du courant d'alimentation du dispositif pour différentes concentrations massiques d'indium dans des couches de la zone active ;
la figure 12 représente une courbe d'évolution de l'efficacité quantique interne maximale de la zone active du dispositif électroluminescent représenté en figure 3 en fonction de la différence, exprimé en points de pourcentage, entre les concentrations massiques d'indium maximale et minimale dans la zone active ;
les figures 13 et 14 représentent des courbes d'évolution de l'efficacité quantique interne de la zone active du dispositif électroluminescent représenté en figure 3 en fonction de la densité surfacique du courant d'alimentation du dispositif pour plusieurs différences de concentrations massiques d'indium dans la zone active pour une concentration massique moyenne d'indium respectivement de 10 % et de 25 % ; et
la figure 15 est une vue en coupe, partielle et schématique, d'un autre mode de réalisation d'un dispositif électroluminescent à structure tridimensionnelle de type radiale ;
la figure 16 est une vue en coupe, partielle et schématique, d'un mode de réalisation d'un réacteur à une étape d'un mode de réalisation d'un procédé de fabrication d'un dispositif électroluminescent à structure tridimensionnelle de type radiale ; et
la figure 17 est une vue en coupe, partielle et schématique, d'un autre mode de réalisation d'un dispositif électroluminescent à structure tridimensionnelle de type radiale.

### Description détaillée

Par souci de clarté, de mêmes éléments ont été désignés par de mêmes références aux différentes figures et, de plus, comme cela est habituel dans la représentation des circuits électroniques, les diverses figures ne sont pas tracées à l'échelle. En outre, seuls les éléments utiles à la compréhension de la présente description ont été représentés et sont décrits. En particulier, les moyens de commande des dispositifs électroluminescents décrits ci-après sont à la portée de l'homme de l'art et ne sont pas décrits. Dans la suite de la description, sauf indication contraire, les termes "sensiblement", "environ" et "de l'ordre de" signifient "à 10 % près".

La présente invention concerne un dispositif électroluminescent comprenant une zone active à puits quantiques multiples. La zone active comprend une alternance de couches semiconductrices à large bande interdite, appelées également couches semiconductrices de grand gap, et de couches semiconductrices à bande interdite étroite, appelées également couches semiconductrices de petit gap, chaque couche semiconductrice de petit gap étant prise en sandwich entre deux couches semiconductrices de grand gap. A titre d'exemple, chaque couche semiconductrice de grand gap comprend majoritairement un composé binaire comportant au moins un premier élément du groupe III et un deuxième élément du groupe V, appelé par la suite composé III-V. A titre d'exemple, chaque couche semiconductrice de petit gap comprend un composé ternaire comprenant un troisième élément en plus du premier élément du groupe III et du deuxième élément du groupe V.

Des exemples d'éléments du groupe III comprennent le gallium (Ga), l'indium (In) ou l'aluminium (Al). Des exemples d'éléments du groupe V comprennent l'azote, le phosphore ou l'arsenic. Des exemples de composés III-N binaires et ternaires sont GaN, AlN, InN, InGaN, AlGaN ou AlInGaN. De façon générale, les éléments dans le composé III-V peuvent être combinés avec différentes fractions molaires. Dans le cas d'un composé III-V, le troisième élément peut correspondre à un élément du groupe III autre que le premier élément.

Il existe des dispositifs électroluminescents à structure bidimensionnelle dans lesquels la zone active est composée d'une couche ou de plusieurs couches sensiblement planes.

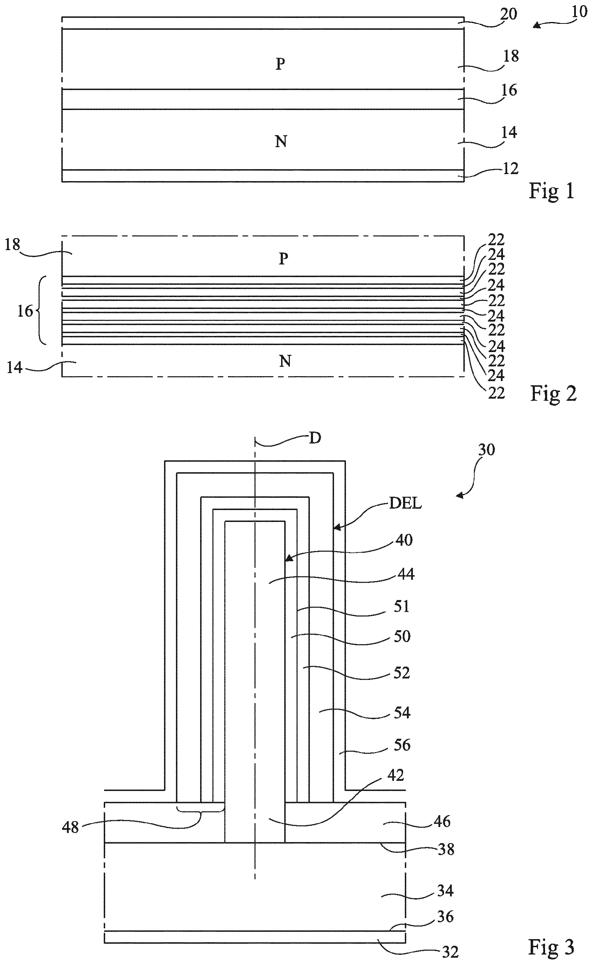

La figure 1 est une vue en coupe d'un exemple d'un dispositif électroluminescent 10 à structure bidimensionnelle.

Le dispositif 10 comprend, du bas vers le haut en figure 1 :
une première électrode de polarisation 12 ;
une couche semiconductrice 14 dopée d'un premier type de conductivité, par exemple dopée de type N ;
une zone active 16 ;
une couche semiconductrice 18 dopée d'un deuxième type de conductivité, par exemple dopée de type P ; et
une seconde électrode de polarisation 20.

Lorsqu'une tension est appliquée entre les électrodes 20 et 12, un rayonnement lumineux est émis par la zone active 16.

La figure 2 représente une vue agrandie de la figure 1 dans le cas où la zone active 16 comprend des puits quantiques multiples. La zone active 16 est, par exemple, constituée d'une alternance de couches de grand gap 22, par exemple en GaN et de couches de petit gap 24, par exemple en InGaN, six couches 22 de grand gap et cinq couches 24 de petit gap étant représentées à titre d'exemple en figure 2. Les couches 22 de grand gap peuvent être dopées, par exemple de type N ou P, ou non dopées.

La présente description concerne des dispositifs électroluminescents à structure tridimensionnelle de type radiale dans lesquels la zone active est formée sur des éléments semiconducteurs ayant la forme de microfils, de nanofils ou de pyramides.

Le terme "microfil" ou "nanofil" désigne une structure tridimensionnelle de forme allongée, par exemple cylindrique, conique ou tronconique, selon une direction privilégiée dont au moins deux dimensions, appelées dimensions mineures, sont comprises entre 5 nm et 2,5 µm, de préférence entre 50 nm et 2,5 µm, la troisième dimension, appelée dimension majeure, étant supérieure ou égale à 1 fois, de préférence supérieure ou égale à 5 fois et encore plus préférentiellement supérieure ou égale à 10 fois, la plus grande des dimensions mineures. Dans certains modes de réalisation, les dimensions mineures peuvent être inférieures ou égales à environ 1 µm, de préférence comprises entre 100 nm et 1 µm, plus préférentiellement entre 100 nm et 800 nm. Dans certains modes de réalisation, la hauteur de chaque microfil ou nanofil peut être supérieure ou égale à 500 nm, de préférence comprise entre 1 µm et 50 µm.

Dans la suite de la description, on utilise le terme "fil" pour signifier "microfil ou nanofil". De préférence, la ligne moyenne du fil qui passe par les barycentres des sections droites, dans des plans perpendiculaires à la direction privilégiée du fil, est sensiblement rectiligne et est appelée par la suite "axe" du fil. La base du fil a, par exemple, une forme ovale, circulaire ou polygonale, notamment triangulaire, rectangulaire, carrée ou hexagonale. On appelle diamètre moyen du fil, le diamètre d'un fil à base circulaire dont la surface est la même que la surface de la base du fil considéré.

Dans la suite de la description, le terme pyramide ou pyramide tronquée désigne une structure tridimensionnelle de forme pyramidale. Cette structure pyramidale peut être tronquée, c'est-à-dire que le haut du cône est absent, laissant place à un plateau. La base de la pyramide est inscrite dans un polygone dont la dimension des côtés est de 100 nm à 10 µm, préférentiellement entre 1 et 3 µm. Le polygone formant la base de la pyramide peut être un hexagone. La hauteur de la pyramide entre la base de la pyramide et le sommet ou le plateau sommital varie de 100 nm à 20 µm, préférentiellement entre 1 µm et 10 µm.

La figure 3 est une coupe, partielle et schématique, d'un mode de réalisation d'un dispositif électroluminescent 30 réalisé à partir de fils tels que décrits précédemment et adapté à émettre un rayonnement électromagnétique.

Le dispositif 30 comprend, du bas vers le haut en figure 3 :
une première électrode de polarisation 32 ;
un substrat 34, par exemple semiconducteur, comprenant des faces parallèles 36 et 38, la face 36 étant au contact de l'électrode 32 ;
des éléments semiconducteurs 40, qui dans le présent mode de réalisation correspondent à des fils, un seul fil 40 d'axe D étant représenté, chaque fil 40 pouvant comprendre une portion inférieure 42, en contact avec le substrat 34, se prolongeant par une portion supérieure 44 ;
une couche isolante 46 recouvrant le substrat 34 et la périphérie de la portion inférieure 42 de chaque fil 20 ;
une coque 48 recouvrant la portion supérieure 44 de chaque fil 40, la coque 48 comprenant au moins un empilement d'une couche d'interface 50 recouvrant la portion supérieure 44 et ayant une paroi externe latérale 51, d'une zone active 52 recouvrant la couche d'interface 50, et d'une couche semiconductrice 54 recouvrant la zone active 52 ; et
une couche de seconde électrode 56 recouvrant chaque coque 48.

Lorsqu'une tension est appliquée entre les électrodes 56 et 32, un rayonnement lumineux est émis par la zone active 52.

L'ensemble formé par un fil 40 et la coque 48 constitue une diode électroluminescente DEL. Lorsque plusieurs diodes électroluminescentes DEL sont formées sur le substrat 34, elles peuvent être connectées en série et/ou en parallèle et former un ensemble de diodes électroluminescentes. L'ensemble peut comprendre de quelques diodes électroluminescentes DEL à un millier de diodes électroluminescentes DEL.

Dans la suite de la description, on appelle extrémité inférieure de la partie efficace d'une couche de la coque 48, également appelée extrémité inférieure efficace, l'extrémité axiale la plus proche du substrat 34 de la partie de cette couche qui est en vis-à-vis de la seconde électrode 56 et on appelle extrémité supérieure de la partie efficace d'une couche de la coque 48, également appelée extrémité supérieure efficace, l'extrémité axiale la plus éloignée du substrat 34 de la partie de cette couche qui est en vis-à-vis de la seconde électrode 56. En figure 3, la seconde électrode 56 recouvre la totalité de la coque 48. De ce fait, l'extrémité efficace inférieure de la zone active 52 est confondue avec l'extrémité axiale de la zone active 52 la plus proche du substrat 34 et l'extrémité efficace supérieure de la zone active 52 est confondue avec l'extrémité axiale de la zone active 52 la plus éloignée du substrat 34. A titre de variante, la seconde électrode 56 peut ne recouvrir qu'une partie de la coque 48, par exemple ne pas recouvrir la base de la coque 48 ou le sommet de la coque 48. Dans ce cas, l'extrémité efficace inférieure de la zone active 52 peut être différente de l'extrémité axiale de la zone active 52 la plus proche du substrat 34 et l'extrémité efficace supérieure de la zone active 52 peut être différente de l'extrémité axiale de la zone active 52 la plus éloignée du substrat 34. Dans la suite de la description, on appelle hauteur efficace de la zone active 52, la hauteur mesurée selon l'axe D de la partie de la zone active 52 en vis-à-vis de la seconde électrode 56.

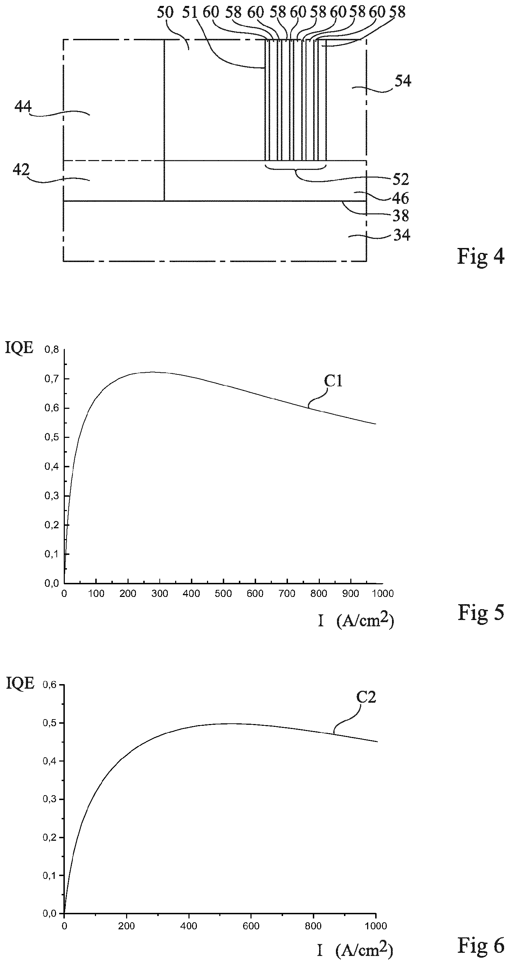

La figure 4 représente une vue agrandie de la figure 3 dans le cas où la zone active 52 comprend des puits quantiques multiples. La zone active 52 est, par exemple, constituée d'une alternance de couches de grand gap 58, par exemple en GaN, et de couches de petit gap 60, par exemple en InGaN, cinq couches 58 de grand gap et cinq couches 60 de petit gap étant représentées à titre d'exemple en figure 4. Les couches 58 de grand gap peuvent être dopées, par exemple de type N ou P, ou non dopées. La zone active 52 peut comprendre de 3 à 20 couches de petit gap 60.

Le dispositif 30 décrit en figure 3 fonctionne convenablement mais présente certains inconvénients. En effet, dans les mêmes conditions d'utilisation et pour des puits quantiques ayant la même composition, l'efficacité quantique interne de la zone active 52 du dispositif électroluminescent 30 est inférieure à l'efficacité quantique interne de la zone active 16 du dispositif électroluminescent 10.

La figure 5 représente une courbe d'évolution C1, obtenue par simulation, de l'efficacité quantique interne IQE de la zone active 16 du dispositif électroluminescent 10, telle que représentée en figure 2, en fonction de la densité surfacique du courant d'alimentation I fourni à l'électrode 20. Pour la simulation, la couche 14 était une couche de GaN dopé de type N avec une concentration de dopants de 10¹⁹ atomes/cm³ et la couche 18 était une couche de GaN dopée de type P avec une concentration de dopants de 10¹⁹ atomes/cm³. Les couches 22 de grand gap étaient des couches de GaN non intentionnellement dopées. Les quatre couches 22 de grand gap les plus proches de la couche 14 de type N avaient une épaisseur de 5 nm et la couche 22 de grand gap la plus proche de la couche 18 de type P avait une épaisseur de 30 nm. Les couches 24 de petit gap étaient des couches de In_{0,16}Ga_{0,84}N non intentionnellement dopées. Comme cela apparaît en figure 5, l'efficacité quantique interne maximale est d'environ 75 %.

La figure 6 représente une courbe d'évolution C2, obtenue par simulation, de l'efficacité quantique interne IQE de la zone active 52 du dispositif électroluminescent 30, telle que représentée en figure 4, en fonction de la densité surfacique de courant d'alimentation I fourni à l'électrode 56. Pour la simulation, le fil 40 était en GaN dopé de type N avec une concentration de dopants de 10¹⁹ atomes/cm³. La couche d'interface 50 était une couche de GaN non intentionnellement dopée. La couche 54 était une couche de GaN dopée de type P avec une concentration de dopants de 10¹⁹ atomes/cm³. Les couches 58 de grand gap étaient des couches de GaN non intentionnellement dopées. Les quatre couches 58 de grand gap les plus proches de la couche d'interface 50 avaient une épaisseur de 5 nm et la couche 58 de grand gap la plus proche de la couche 54 de type P avait une épaisseur de 30 nm. Les couches 60 de petit gap étaient des couches de In_{0,16}Ga_{0,84}N non intentionnellement dopées. La hauteur, mesurée selon l'axe D, de la paroi latérale du fil 40 recouverte par la coque 48 était de 4 µm. Comme cela apparaît en figure 6, l'efficacité quantique interne maximale est d'environ 55 % et est donc inférieure à l'efficacité quantique interne de la zone active 16 du dispositif électroluminescent 10.

Une explication serait que, dans le dispositif électroluminescent à structure bidimensionnelle 10, les électrodes 12 et 20 sont disposées de façon symétrique de part et d'autre de la zone active 16. Ceci entraînerait une répartition sensiblement homogène du courant traversant la zone active 16 et donc une génération homogène de lumière dans la zone active 16. Dans le dispositif électroluminescent 30 à structure tridimensionnelle, les électrodes 32 et 56 ne sont pas disposées de façon symétrique de part et d'autre de la zone active 52. Le courant tendrait alors à emprunter de façon privilégiée le chemin dont la résistance est la plus faible, c'est-à-dire en passant de façon privilégiée par l'extrémité inférieure de la zone active 52. Il n'y a donc pas une distribution homogène du courant dans la zone active 52, ce qui entraîne une diminution de l'émission globale de lumière par la zone active 52.

Les inventeurs ont mis en évidence qu'une augmentation de la quantité de lumière émise peut être obtenue en faisant varier la concentration massique du troisième élément dans au moins certaines couches de petit gap de la zone active 52 entre l'extrémité supérieure efficace de la zone active 52 et l'extrémité inférieure efficace de la zone active 52.

Selon un mode de réalisation, pour au moins trois couches de petit gap 60, la concentration massique du troisième élément dans la couche de petit gap augmente de l'extrémité supérieure efficace vers l'extrémité inférieure efficace de la couche de petit gap. De façon surprenante, les inventeurs ont mis en évidence que l'efficacité quantique interne de la zone active 52 du dispositif électroluminescent 30 à structure tridimensionnelle pouvait même être supérieure à l'efficacité quantique interne de la zone active 16 de même composition du dispositif électroluminescent 10 à structure bidimensionnelle.

Selon un mode de réalisation, dans chaque couche de petit gap dans laquelle la concentration massique du troisième élément varie, la différence entre la concentration massique maximale du troisième élément à l'extrémité inférieure efficace de la couche de petit gap et la concentration massique minimale du troisième élément à l'extrémité supérieure efficace de la couche de petit gap est comprise entre 0,1 point de pourcentage et 9 points de pourcentage, de préférence entre 1 point de pourcentage et 9 points de pourcentage.

Selon un mode de réalisation, dans chaque couche de petit gap dans laquelle la concentration massique du troisième élément varie, la concentration massique moyenne du troisième élément est comprise entre 6 % et 25 %.

Selon un mode de réalisation, dans chaque couche de petit gap dans laquelle la concentration massique du troisième élément varie, la concentration massique du troisième élément croît strictement de l'extrémité inférieure efficace de la couche de petit gap à l'extrémité supérieure efficace de la couche de petit gap. A titre d'exemple, la variation de la concentration massique du troisième élément de l'extrémité inférieure efficace à l'extrémité supérieure efficace de la couche de petit gap peut être sensiblement linéaire.

Selon un mode de réalisation, dans chaque couche de petit gap dans laquelle la concentration massique du troisième élément varie, lorsque l'on considère une portion de la couche de petit gap dont la dimension, mesurée selon l'axe D, est égale à 10 % de la hauteur efficace de la couche de petit gap, la variation de la concentration massique du troisième élément entre l'extrémité axiale inférieure et l'extrémité axiale supérieure de cette portion est inférieure à 50 % de la variation de la concentration massique du troisième élément entre l'extrémité inférieure efficace et l'extrémité supérieure efficace de la couche de petit gap.

Selon un mode de réalisation, l'épaisseur de chaque couche de petit gap 60 est comprise entre 1 nm et 10 nm. Selon un mode de réalisation, l'épaisseur de chaque couche de grand gap 58 est comprise entre 1 nm et 25 nm.

Le substrat 34 peut correspondre à une structure monobloc ou correspondre à une couche recouvrant un support constitué d'un autre matériau. Le substrat 34 est de préférence un substrat semiconducteur, par exemple un substrat en silicium, en germanium, en carbure de silicium, en un composé III-V, tel que du GaN ou du GaAs, ou un substrat en ZnO. De préférence, le substrat 34 est un substrat de silicium monocristallin. De préférence, il s'agit d'un substrat semiconducteur compatible avec les procédés de fabrication mis en oeuvre en microélectronique. Le substrat 34 peut correspondre à une structure multicouches de type silicium sur isolant, également appelée SOI (acronyme anglais pour Silicon On Insulator). Le substrat 34 peut être fortement dopé, faiblement dopé ou non dopé.

L'électrode 32 peut correspondre à une couche conductrice qui s'étend sur la face 36 du substrat 34. Le matériau formant l'électrode 32 est, par exemple, du siliciure de nickel (NiSi), de l'aluminium (Al), du siliciure d'aluminium (AISi), du titane (Ti) ou du siliciure de titane (TiSi).

Dans le mode de réalisation représenté, l'élément semiconducteur 40 est au contact de la face 38 du substrat 34. A titre de variante, une couche de germination en un matériau favorisant la croissance des éléments semiconducteurs 40 peut être interposée entre le substrat 34 et les éléments semiconducteurs 40. A titre d'exemple, le matériau composant la couche de germination peut être un nitrure, un carbure ou un borure d'un métal de transition de la colonne IV, V ou VI du tableau périodique des éléments ou une combinaison de ces composés. A titre d'exemple, la couche de germination peut être en nitrure d'aluminium (AIN), en oxyde d'aluminium (Al₂O₃), en bore (B), en nitrure de bore (BN), en titane (Ti), en nitrure de titane (TiN), en tantale (Ta), en nitrure de tantale (TaN), en hafnium (Hf), en nitrure d'hafnium (HfN), en niobium (Nb), en nitrure de niobium (NbN), en zirconium (Zr), en borate de zirconium (ZrB₂), en nitrure de zirconium (ZrN), en carbure de silicium (SiC), en nitrure et carbure de tantale (TaCN), ou en nitrure de magnésium sous la forme MgₓN_{y}, où x est environ égal à 3 et y est environ égal à 2, par exemple du nitrure de magnésium selon la forme Mg₃N₂. La couche de germination peut être dopée du même type de conductivité que le substrat 34. La couche de germination a, par exemple, une épaisseur comprise entre 1 et 100 nanomètres, de préférence comprise entre 10 et 30 nanomètres. A titre de variante, la couche de germination peut être remplacée par des plots de germination reposant sur la face 38 du substrat 34, chaque fil 40 reposant sur l'un des plots de germination.

La couche isolante 46 peut être en un matériau diélectrique, par exemple en oxyde de silicium (SiO₂), en nitrure de silicium (SiₓN_{y}, où x est environ égal à 3 et y est environ égal à 4, par exemple du Si₃N₄), en oxynitrure de silicium (notamment de formule générale SiOₓN_{y}, par exemple du Si₂ON₂), en oxyde d'hafnium (HfO₂) ou en diamant. A titre d'exemple, l'épaisseur de la couche isolante 46 est comprise entre 1 nm et 20 µm, de préférence entre 5 nm et 100 nm.

Les éléments semiconducteurs 40 sont, au moins en partie, formés à partir d'au moins un matériau semiconducteur. Le matériau semiconducteur est choisi parmi le groupe comprenant les composés III-V, les composés II-VI ou les composés du groupe IV. Des exemples de composés III-V sont ceux décrits précédemment pour la zone active 52. Des exemples d'éléments du groupe II comprennent des éléments du groupe IIA, notamment le béryllium (Be) et le magnésium (Mg) et des éléments du groupe IIB, notamment le zinc (Zn), le cadmium (Cd) et le mercure (Hg). Des exemples d'éléments du groupe VI comprennent des éléments du groupe VIA, notamment l'oxygène (O) et le tellure (Te). Des exemples de composés II-VI binaires et ternaires sont ZnO, ZnMgO, CdZnO, CdZnMgO, CdHgTe, CdTe ou HgTe. De façon générale, les éléments dans le composé II-VI peuvent être combinés avec différentes fractions molaires. Des exemples de matériaux semiconducteurs du groupe IV sont le silicium (Si), le carbone (C), le germanium (Ge), les alliages de carbure de silicium (SiC), les alliages silicium-germanium (SiGe) ou les alliages de carbure de germanium (GeC).

Les éléments semiconducteurs 40 peuvent comprendre un dopant. A titre d'exemple, pour des composés III-V, le dopant peut être choisi parmi le groupe comprenant un dopant de type P du groupe II, par exemple, du magnésium (Mg), du zinc (Zn), du cadmium (Cd) ou du mercure (Hg), un dopant du type P du groupe IV, par exemple du carbone (C) ou un dopant de type N du groupe IV, par exemple du silicium (Si), du germanium (Ge), du sélénium (Se), du souffre (S), du terbium (Tb) ou de l'étain (Sn).

Lorsque les éléments semiconducteurs tridimensionnels 40 du dispositif électroluminescent correspondent à des fils, la hauteur de chaque fil peut être comprise entre 250 nm et 50 µm. Chaque fil 40 peut avoir une structure semiconductrice allongée selon un axe D sensiblement perpendiculaire à la face 38. Chaque fil 40 peut avoir une forme générale cylindrique, dont la base a, par exemple, une forme ovale, circulaire ou polygonale, notamment triangulaire, rectangulaire, carrée ou hexagonale. Les axes de deux fils 40 adjacents peuvent être distants de 0,5 µm à 10 µm et de préférence de 1,5 µm à 5 µm. A titre d'exemple, les fils 40 peuvent être régulièrement répartis, notamment selon un réseau hexagonal.

Selon un mode de réalisation, la portion inférieure 42 de chaque fil est principalement constituée d'un composé III-N, par exemple du nitrure de gallium, dopé d'un premier type de conductivité, par exemple de type N. Le dopant de type N peut être le silicium. La hauteur de la portion inférieure 42 peut être comprise entre 500 nm et 25 µm.

Selon un mode de réalisation, la portion supérieure 44 de chaque fil est, par exemple, au moins partiellement réalisée dans un composé III-N, par exemple du nitrure de gallium. La portion 44 peut être dopée du premier type de conductivité, par exemple de type N, ou ne pas être dopée de façon intentionnelle. La hauteur de la portion supérieure 44 peut être comprise entre 500 nm et 25 µm.

Lorsque les éléments semiconducteurs tridimensionnels 40 du dispositif électroluminescent 30 correspondent à des pyramides, la hauteur de chaque pyramide peut être comprise entre 100 nm et 25 µm. Chaque pyramide peut avoir une structure semiconductrice allongée selon un axe sensiblement perpendiculaire à la face 38. La base de chaque pyramide peut avoir une forme générale de type ovale, circulaire ou polygonale, notamment triangulaire, rectangulaire, carrée ou hexagonale. Les centres de deux pyramides adjacentes peuvent être distants de 0,25 µm à 10 µm et de préférence de 1,5 µm à 5 µm. A titre d'exemple, les pyramides peuvent être régulièrement réparties, notamment selon un réseau hexagonal.

La couche semiconductrice 54 peut comprendre un empilement de plusieurs couches.

L'électrode 56 est adaptée à polariser la zone active 52 recouvrant chaque élément semiconducteur 40 et à laisser passer le rayonnement électromagnétique émis par les diodes électroluminescentes DEL. Le matériau formant l'électrode 56 peut être un matériau transparent et conducteur tel que de l'oxyde d'indium-étain (ou ITO, acronyme anglais pour Indium Tin Oxide), de l'oxyde de zinc dopé ou non à l'aluminium ou au gallium, ou du graphène. A titre d'exemple, la couche d'électrode 56 a une épaisseur comprise entre 5 nm et 200 nm, de préférence entre 20 nm et 50 nm.

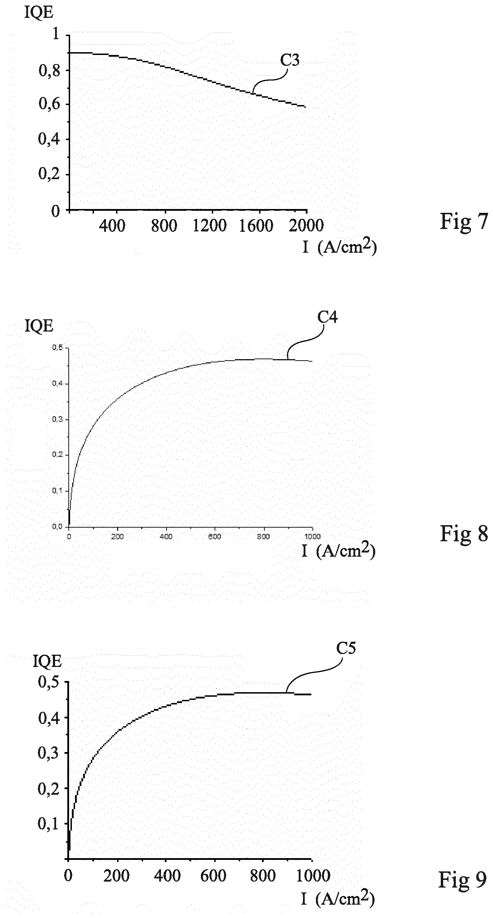

Les figures 7 à 11 représentent des courbes d'évolution respectivement C3, C4, C5, C6 et C7, obtenues par simulation, de l'efficacité quantique interne de la zone active 52 du dispositif électroluminescent 30 représenté en figure 3 en fonction de la densité surfacique du courant d'alimentation I fourni à l'électrode pour différentes concentrations massiques d'indium dans les couches de petit gap 60. Pour ces figures, les simulations ont été réalisées avec les mêmes paramètres que ceux décrits précédemment pour l'obtention de la courbe C2 à la différence que la concentration massique d'indium dans chaque couche de petit gap 60 a été modifiée.

Le tableau 1 suivant rassemble les paramètres des différentes simulations pour l'obtention des courbes C3, C4, C5, C6 et C7 et indique l'efficacité quantique interne maximale obtenue. La concentration Cmoy est égale à la concentration massique moyenne d'indium dans les couches de petit gap 60. La concentration Ctop est égale à la concentration massique dans les couches de petit gap 60 à l'extrémité supérieure de la zone active 52. La concentration Cbottom est égale à la concentration massique dans les couches de petit gap 60 à l'extrémité inférieure de la zone active 52. Le paramètre Delta correspond à la différence, exprimée en points de pourcentage, entre la concentration massique d'indium à l'extrémité inférieure des couches de petit gap 60 et l'extrémité supérieure des couches de petit gap 60. La concentration massique d'indium varie linéairement en fonction de la position suivant l'axe D. L'efficacité quantique interne maximale est notée IQEmax.

**Tableau 1**

| Figure | Courbe | Cmoy (%) | Ctop (%) | Cbottom (%) | Delta (point de pourcentage) | IQEmax (%) |
|---|---|---|---|---|---|---|
| 7 | C3 | 14,5 | 13 | 16 | 3 | 90 % |
| 8 | C4 | 14,5 | 16 | 13 | -3 | 55 % |
| 9 | C5 | 10,05 | 20 | 0.1 | -19.05 | 45 % |
| 10 | C6 | 13 | 25 | 1 | -24 | 25 % |
| 11 | C7 | 13 | 1 | 25 | 24 | 25 % |

Pour la courbe C3, l'efficacité quantique maximale est de 90 %, c'est-à-dire supérieure au cas où le dispositif électroluminescent a une structure bidimensionnelle. Pour la courbe C4, l'efficacité quantique maximale est de 55 %, c'est-à-dire du même ordre que dans le cas où la concentration massique d'indium est constante. Pour la courbe C5, C6 et C7, l'efficacité quantique maximale est inférieure au cas où la concentration massique d'indium est constante.

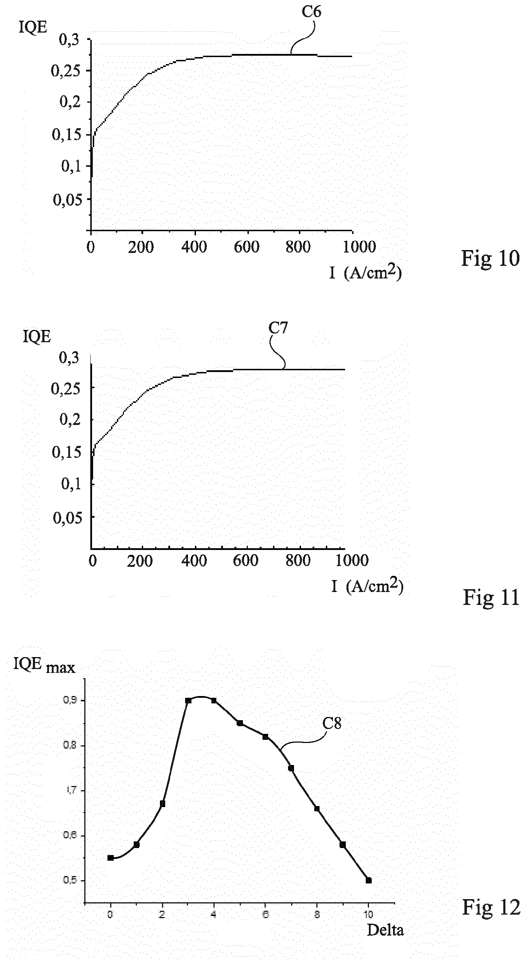

La figure 12 représente une courbe d'évolution C8 du maximum de l'efficacité quantique interne IQEₘₐₓ de la zone active 52 du dispositif électroluminescent 30 représenté en figure 3 en fonction de l'écart Delta, exprimé en points de pourcentage, entre la concentration massique d'indium maximale dans les couches de petit gap 60 à l'extrémité inférieure de la zone active 52 et la concentration massique d'indium minimale dans les couches de petit gap 60 à l'extrémité supérieure de la zone active 52.

Une augmentation de l'efficacité quantique interne maximale par rapport au cas où la concentration massique d'indium est constante est obtenue lorsque la différence de concentrations entre la concentration à l'extrémité inférieure de la zone active 52 et la concentration à l'extrémité supérieure de la zone active 52, exprimée en points de pourcentage est comprise entre 0,1 point de pourcentage et 9 points de pourcentage, la concentration à l'extrémité inférieure de la zone active 52 étant supérieure strictement à la concentration à l'extrémité supérieure de la zone active 52.

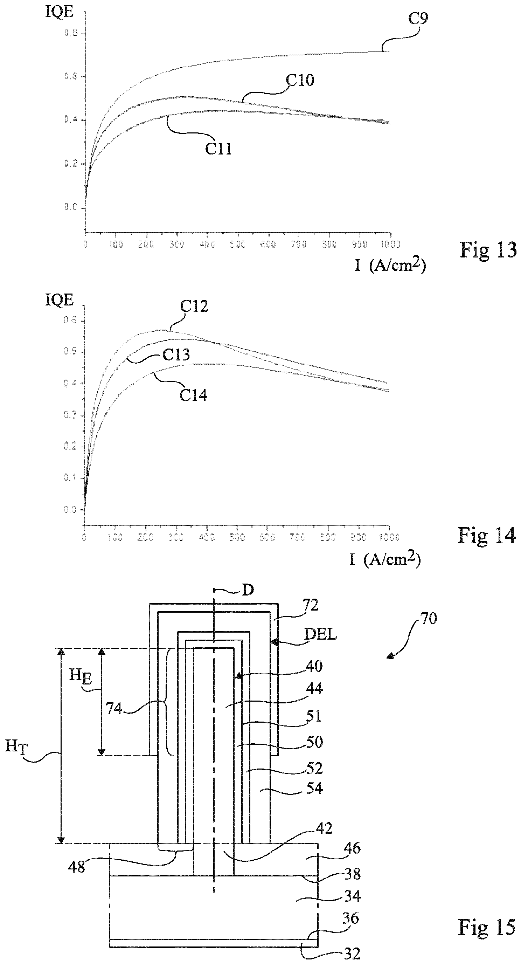

Les figures 13 et 14 représentent des courbes d'évolution C9, C10, C11, C12, C13 et C14, obtenues par simulation, de l'efficacité quantique interne de la zone active 52 du dispositif électroluminescent 30 représenté en figure 3 en fonction de la densité surfacique du courant d'alimentation I fourni à l'électrode pour différentes concentrations massiques d'indium dans les couches de petit gap 60 et différentes concentrations massiques moyennes d'indium dans les couches de petit gap 60. Pour ces figures, les simulations ont été réalisées avec les mêmes paramètres que ceux décrits précédemment pour l'obtention de la courbe C2 à la différence que la concentration massique d'indium dans chaque couche de petit gap 60 a été modifiée. En particulier, pour ces simulations, la concentration massique d'indium varie linéairement en fonction de la position suivant l'axe D.

Le tableau 2 suivant rassemble les paramètres des différentes simulations pour l'obtention des courbes C9, C10, C11, C12, C13 et C14 et indique l'efficacité quantique interne maximale obtenue.

**Tableau 2**

| Figure | Courbe | Cmoy (%) | Ctop (%) | Cbottom (%) | Delta (point de pourcentage) | IQEmax (%) |
|---|---|---|---|---|---|---|
| 13 | C9 | 10 | 8 | 12 | 4 | 0,7 |
| 13 | C10 | 10 | 10 | 10 | 0 | 0,5 |
| 13 | C11 | 10 | 12 | 8 | -4 | 0,43 |
| 14 | C12 | 25 | 23 | 27 | 4 | 0,57 |
| 14 | C13 | 25 | 25 | 25 | 0 | 0,53 |
| 14 | C14 | 25 | 27 | 23 | -4 | 0,45 |

Quelle que soit la concentration massique moyenne d'indium, lorsque la concentration massique d'indium dans la couche de petit gap 60 augmente de l'extrémité supérieure à l'extrémité inférieure de la zone active 52, l'efficacité quantique interne maximale est augmentée par rapport au cas où la concentration massique d'indium est sensiblement constante. En outre, lorsque la concentration massique d'indium dans la couche de petit gap 60 diminue de l'extrémité supérieure à l'extrémité inférieure de la zone active 52, l'efficacité quantique interne maximale est réduite par rapport au cas où la concentration massique d'indium est sensiblement constante.

La figure 15 représente un autre mode de réalisation d'un dispositif électroluminescent 70. Le dispositif électroluminescent 70 comprend l'ensemble des éléments du dispositif électroluminescent 30 représenté en figure 3 à la différence que l'électrode 56 est remplacée par une électrode 72 qui ne recouvre pas complétement les parois latérales extérieures de la coque 48. De préférence, l'électrode 72 s'étend sur une hauteur H_{E} mesurée selon l'axe D qui est égale à une partie de la hauteur totale H_{T} du fil 40 recouverte de la coque 48. De préférence, la hauteur H_{E} est supérieure ou égale à 1 µm.

Dans ce mode de réalisation, la variation de concentration du troisième élément dans les couches de petit gap 60, comprise entre 0,1 point de pourcentage et 9 points de pourcentage, est prévue entre l'extrémité supérieure et l'extrémité inférieure de la partie 74 de la zone active 52 prise en sandwich entre l'électrode 72 et la paroi latérale externe de la couche d'interface 50. En effet, les inventeurs ont mis en évidence que les variations de la concentration du troisième élément dans les couches de petit gap 60 en dehors de cette partie 74 de la zone active 52 influaient peu sur l'efficacité quantique interne de la zone active 52.

Le procédé de croissance de chaque élément semiconducteur 40 et des couches composant la coque 48 recouvrant l'élément semiconducteur 40 peut être un procédé du type dépôt chimique en phase vapeur (CVD, sigle anglais pour Chemical Vapor Deposition) ou dépôt chimique en phase vapeur aux organométalliques (MOCVD, acronyme anglais pour Metal-Organic Chemical Vapor Deposition), également connu sous le nom d'épitaxie organométallique en phase vapeur (ou MOVPE, acronyme anglais pour Metal-Organic Vapor Phase Epitaxy). Toutefois, des procédés tels que l'épitaxie par jets moléculaires (MBE, acronyme anglais pour Molecular-Beam Epitaxy), la MBE à source de gaz (GSMBE), la MBE organométallique (MOMBE), la MBE assistée par plasma (PAMBE), l'épitaxie par couche atomique (ALE, acronyme anglais pour Atomic Layer Epitaxy) ou l'épitaxie en phase vapeur aux hydrures (HVPE, acronyme anglais pour Hydride Vapor Phase Epitaxy) peuvent être utilisés. Toutefois, des procédés électrochimiques peuvent être utilisés, par exemple, le dépôt en bain chimique (CBD, sigle anglais pour Chemical Bath Deposition), les procédés hydrothermiques, la pyrolise d'aérosol liquide ou l'électrodépôt.

A titre d'exemple, le procédé peut comprendre l'injection dans un réacteur d'un précurseur du premier élément du groupe III et d'un précurseur du deuxième élément du groupe V et, éventuellement, d'un précurseur du troisième élément.

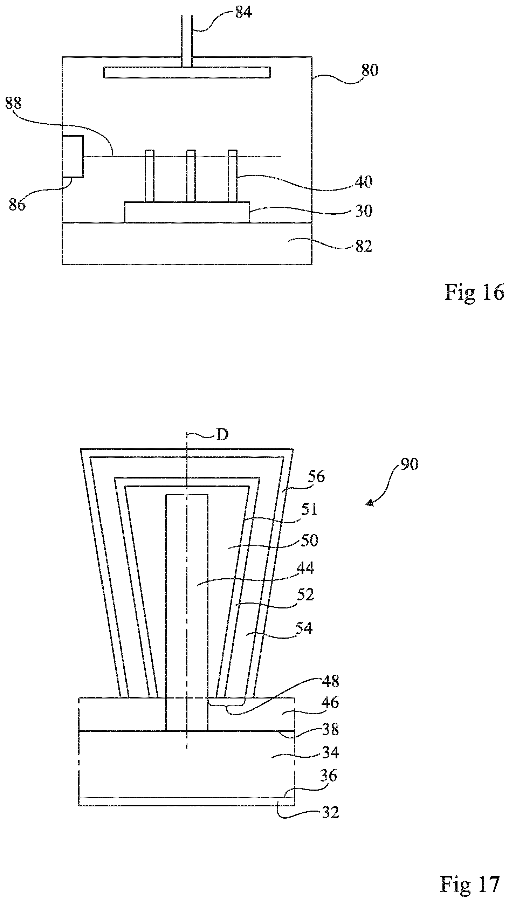

La figure 16 représente de façon très schématique un réacteur 80, par exemple un réacteur MOCVD pour la mise en oeuvre d'un mode de réalisation d'un procédé de fabrication du dispositif électroluminescent 30 dans lequel un gradient de température est appliqué à chaque élément semiconducteur 40 au cours de la croissance des couches de petit gap 60 de la zone active 52, de façon que l'extrémité supérieure de l'élément semiconducteur 40 soit à une température plus élevée que la base de l'élément semiconducteur 40. L'incorporation d'indium dans la couche de petit gap 60 au cours de la croissance est alors d'autant plus importante que la température de l'élément semiconducteur 40 est faible. On obtient ainsi un gradient de concentration d'indium selon l'axe de l'élément semiconducteur 40. Selon un mode de réalisation, le dispositif 30 repose sur un suscepteur 82. Des conduites 84 permettent l'apport de gaz précurseurs dans le réacteur 80. Pour obtenir un gradient de température, une source laser 86 est adaptée à émettre une nappe laser 88 pour chauffer les extrémités des fils 40.

La figure 17 représente un autre mode de réalisation d'un dispositif électroluminescent 90. Le dispositif électroluminescent 90 comprend l'ensemble des éléments du dispositif électroluminescent 30 représenté en figure 3 à la différence que le diamètre moyen de la paroi latérale 51 de la couche d'interface 50 à l'extrémité supérieure du fil 40 est supérieur strictement au diamètre moyen de la paroi latérale 51 de la couche d'interface 50 à l'extrémité inférieure du fil 40.

Une couche d'interface plus large à l'extrémité supérieure du fil 10 peut être obtenue en faisant varier la température dans le réacteur au cours de la croissance de la couche d'interface 50. Selon un mode de réalisation, la température dans le réacteur est diminuée au cours de la croissance de la couche d'interface 50. Lors de la croissance des couches de petit gap 60, l'incorporation d'indium est d'autant plus importante que le diamètre de la couche de petit gap 60 est faible. On obtient ainsi une concentration d'indium qui augmente de l'extrémité supérieure du fil 40 à l'extrémité inférieure du fil 40.

A titre de variante, le procédé de formation des fils 40 est adapté de façon que le diamètre moyen de chaque fil 40 à l'extrémité supérieure du fil 40 soit supérieur strictement au diamètre moyen du fil 40 à l'extrémité inférieure du fil 40.

Divers modes de réalisation avec diverses variantes ont été décrits ci-dessus. On note que l'homme de l'art peut combiner divers éléments de ces divers modes de réalisation et variantes sans faire preuve d'activité inventive. En particulier, le dispositif électroluminescent 90 représenté en figure 17 peut être réalisé avec une électrode 56 ne recouvrant pas en totalité la coque 48 comme cela est le cas pour le dispositif électroluminescent 70 représenté en figure 15.

## Revendications

1. Dispositif électroluminescent (30 ; 70 ; 90) comprenant :
un substrat (34) ;
des éléments (40) semiconducteurs tridimensionnels reposant sur le substrat ;
pour chaque élément semiconducteur, au moins une coque (48) recouvrant au moins partiellement les parois latérales de l'élément semiconducteur, la coque comprenant une zone active (52) ayant des puits quantiques multiples ; et
une électrode (56 ; 72) recouvrant au moins partiellement la coque (48), au moins une partie (74) de la zone active (52) étant prise en sandwich entre l'électrode et les parois latérales de l'élément semiconducteur (40),
dans lequel la zone active comprend une alternance de premières couches semiconductrices (58) comprenant majoritairement un premier élément et un deuxième élément et de deuxièmes couches semiconductrices (60) comprenant majoritairement le premier élément et le deuxième élément et comprenant, en outre, un troisième élément **caractérisé en ce que**, dans au moins trois des deuxièmes couches, la concentration massique du troisième élément augmente dans ladite partie de la zone active en se rapprochant du substrat.

2. Dispositif électroluminescent selon la revendication 1, dans lequel l'augmentation de la concentration massique du troisième élément est comprise entre 0,1 point de pourcentage et 9 points de pourcentage.

3. Dispositif électroluminescent selon la revendication 1 ou 2, dans lequel, dans chacune desdites trois deuxièmes couches (60), dans n'importe quelle portion de la deuxième couche dont la hauteur est égale à 10 % de la hauteur de ladite partie de la zone active (52) mesurée selon une direction perpendiculaire à une face du substrat (34), la variation de la concentration massique du troisième élément entre les extrémités, selon ladite direction, de cette portion est inférieure à 50 % de la variation de la concentration massique du troisième élément entre les extrémités, selon ladite direction, de ladite partie de la zone active.

4. Dispositif électroluminescent selon l'une quelconque des revendications 1 à 3, dans lequel l'augmentation de la concentration massique du troisième élément est linéaire.

5. Dispositif électroluminescent selon l'une quelconque des revendications 1 à 4, dans lequel chaque première couche (58) comprend majoritairement un composé binaire III-V et chaque deuxième couche (60) comprend le composé III-V dans lequel l'élément de type III est en partie substitué par le troisième élément.

6. Dispositif électroluminescent selon l'une quelconque des revendications 1 à 5, dans lequel la concentration massique moyenne dudit troisième élément dans les deuxièmes couches (60) est comprise entre 6 % et 25 %.

7. Dispositif électroluminescent selon l'une quelconque des revendications 1 à 6, dans lequel, pour au moins l'un des éléments semiconducteurs (40), l'électrode (56) recouvre seulement partiellement la coque (48) recouvrant ledit élément semiconducteur.

8. Dispositif électroluminescent selon l'une quelconque des revendications 1 à 7, dans lequel, pour au moins l'un des éléments semiconducteurs (40), le diamètre moyen extérieur de la zone active (52) augmente en s'éloignant du substrat (34).

9. Dispositif électroluminescent selon l'une quelconque des revendications 1 à 8, dans lequel les éléments semiconducteurs (40) sont des nanofils, des microfils et/ou des structures pyramidales de taille nanométrique ou micrométrique.

10. Procédé de fabrication d'un dispositif électroluminescent (30 ; 70 ; 90) comprenant les étapes suivantes :
former des éléments (40) semiconducteurs tridimensionnels reposant sur un substrat (34) ;
former, pour chaque élément semiconducteur, au moins une coque (48) recouvrant au moins partiellement les parois latérales
de l'élément semiconducteur, la coque comprenant une zone active (52) ayant des puits quantiques multiples ; et
former une électrode (56 ; 72) recouvrant au moins partiellement la coque (48), au moins une partie (74) de la zone active (52) étant prise en sandwich entre l'électrode et les parois latérales de l'élément semiconducteur (40),
dans lequel la zone active comprend une alternance de premières couches semiconductrices (58) comprenant majoritairement un premier élément et un deuxième élément et de deuxièmes couches semiconductrices (60) comprenant majoritairement le premier élément et le deuxième élément et comprenant, en outre, un troisième élément **caractérisé en ce que**, dans au moins trois des deuxièmes couches, la concentration massique du troisième élément augmente dans ladite partie de la zone active en se rapprochant du substrat.

11. Procédé selon la revendication 10, comprenant, pour au moins l'un des éléments semiconducteurs (40), lors de la formation desdites au moins trois deuxièmes couches (60), le maintien d'un gradient de température entre l'extrémité de l'élément semiconducteur la plus éloignée du substrat (34) et l'extrémité de l'élément semiconducteur la plus proche du substrat.

12. Procédé selon la revendication 11, comprenant, pour au moins l'un des éléments semiconducteurs (40), avant la formation desdites au moins trois deuxièmes couches (60), la formation de l'élément semiconducteur ou d'une couche (50) recouvrant l'élément semiconducteur ayant un diamètre moyen externe plus important à l'extrémité de l'élément semiconducteur la plus éloignée du substrat qu'à l'extrémité de l'élément semiconducteur la plus proche du substrat.

## Patentansprüche

1. Leuchtvorrichtung (30; 70; 90), die Folgendes aufweist:
ein Substrat (34);
dreidimensionale Halbleiterelemente (40), die auf dem Substrat ruhen;
für jedes Halbleiterelement zumindest eine Hülle (48), die zumindest teilweise die lateralen Wände des Halbleiterelements abdeckt, wobei die Hülle einen aktiven Bereich (52) mit mehreren Quantentöpfen aufweist; und
eine Elektrode (56; 72) die zumindest teilweise die Hülle (48) abdeckt, wobei zumindest ein Teil (74) des aktiven Bereichs (52) sandwichartig zwischen der Elektrode und den lateralen Wänden des Halbleiterelements (40) eingefügt ist,
wobei der aktive Bereich eine Abänderung erster Halbleiterschichten (58) aufweist, die hauptsächlich ein erstes Element und ein zweites Element aufweist, und zweiter Halbleiterschichten (60), die hauptsächlich das erste Element und das zweite Element und ferner ein drittes Element aufweist, **dadurch gekennzeichnet, dass** in zumindest drei der zweiten Schichten die Massenkonzentration des dritten Elements in dem Teil des aktiven Bereich zunimmt, wenn die Entfernung zu dem Substrat abnimmt.

2. Leuchtvorrichtung gemäß Anspruch 1, wobei die Massenkonzentrationszunahme des dritten Elements in dem Bereich von 0,1 Prozentpunkten bis 9 Prozentpunkten liegt.

3. Leuchtvorrichtung gemäß Anspruch 1 oder 2, wobei in jeder der drei zweiten Schichten (60) in irgendeinem Teil der zweiten Schicht dessen Höhe 10% der Höhe des Teils des aktiven Bereichs (52) entspricht, und zwar entlang einer Richtung senkrecht zu der Oberfläche des Substrats (34) gemessen, die Variation der Massenkonzentration des dritten Elements zwischen den Enden entlang der Richtung dieses Teils kleiner als 50% der Variation der Massenkonzentration des dritten Elements zwischen den Enden entlang der Richtung des Teils des aktiven Bereichs ist.

4. Leuchtvorrichtung gemäß Anspruch 1 bis 3, wobei die Massenkonzentration des dritten Elements linear ansteigt.

5. Leuchtvorrichtung gemäß Anspruch 1 bis 4, wobei jede erste Schicht (58) hauptsächlich eine III-V-Zweifachverbindung aufweist und jede zweite Schicht (60) die III-V-Verbindung aufweist, wobei das Element vom III-Typ teilweise durch das dritte Element substituiert ist.

6. Leuchtvorrichtung gemäß Anspruch 1 bis 5, wobei die durchschnittliche Massenkonzentration des dritten Elements in der zweiten Schicht (60) in dem Bereich von 6% bis 25% liegt.

7. Leuchtvorrichtung gemäß Anspruch 1 bis 6, wobei für zumindest eines der Halbleiterelemente (40) die Elektrode (56) nur teilweise die Hülle (48) abdeckt, die das Halbleiterelement abdeckt.

8. Leuchtvorrichtung gemäß Anspruch 1 bis 7, wobei für zumindest eines der Halbleiterelemente (40) der Außendurchmesser des aktiven Bereichs (52) mit ansteigender Entfernung von dem Substrat (34) ansteigt.

9. Leuchtvorrichtung gemäß Anspruch 1 bis 8, wobei die Halbleiterelemente (40), Nanodrähte, Mikrodrähte und/oder Pyramidenstrukturen im Nanometer- oder Mikrometerbereich sind.

10. Verfahren zur Herstellung einer Leuchtvorrichtung (30; 70; 90), das die folgenden Schritte aufweist:
Bilden von dreidimensionalen Halbleiterelementen (40), die auf einem Substrat (34) ruhen;
Bilden für jedes Halbleiterelement von zumindest einer Hülle (48), die zumindest teilweise die lateralen Wände des Halbleiterelements abdeckt, wobei die Hülle einen aktiven Bereich (52) mit mehreren Quantentöpfen aufweist; und
Bilden einer Elektrode (56; 72), die zumindest teilweise die Hülle (48) abdeckt, wobei zumindest ein Teil (74) der aktiven Schicht (52) sandwichartig zwischen der Elektrode und den lateralen Wänden des Halbleiterelements (40) eingefügt ist,
wobei der aktive Bereich eine Abänderung erster Halbleiterschichten (58) aufweist, die hauptsächlich ein erstes Element und ein zweites Element aufweisen, und zweiter Halbleiterschichten (60), die hauptsächlich das erste Element und das zweite Element und ferner ein drittes Element aufweisen, **dadurch gekennzeichnet, dass** in zumindest drei der zweiten Schichten die Massenkonzentration des dritten Elements in dem Teil des aktiven Bereichs zunimmt, wenn die Entfernung zu dem Substrat abnimmt.

11. Verfahren gemäß Anspruch 10, das für zumindest eines der Halbleiterelemente (40) beim Bilden der zumindest drei zweiten Schichten (60) das Aufrechterhalten eines Temperaturgradienten zwischen dem Ende des Halbleiterelements, das am weitesten von dem Substrat (34) entfernt ist und dem Ende des Halbleiterelements, das am dichtesten an dem Substrat ist, aufweist.

12. Verfahren gemäß Anspruch 11, das für zumindest eines der Halbleiterelemente (40) vor dem Bilden der zumindest drei zweiten Schichten (60), das Bilden des Halbleiterelements oder einer Schicht (50), die das Halbleiterelement abdeckt mit einem größeren durchschnittlichen Außendurchmesser an dem Ende des Halbleiterelements, das am weitesten von dem Substrat entfernt ist, als an dem Ende des Halbleiterelements, das am dichtesten an dem Substrat ist, aufweist.

## Claims

1. A light-emitting device (30; 70; 90) comprising:
a substrate (34);
three-dimensional semiconductor elements (40) resting on the substrate;
for each semiconductor element, at least one shell (48) at least partially covering the lateral walls of the semiconductor element, the shell comprising an active area (52) having multiple quantum wells; and
an electrode (56; 72) at least partially covering the shell (48), at least a portion (74) of the active area (52) being sandwiched between the electrode and the lateral walls of the semiconductor element (40),
wherein the active area comprises an alternation of first semiconductor layers (58) mainly comprising a first element and a second element and of second semiconductor layers (60) mainly comprising the first element and the second element and further comprising a third element, **characterized in that**, in at least three of the second layers, the mass concentration of the third element increases in said portion of the active area as the distance to the substrate decreases.

2. The light-emitting device of claim 1, wherein the mass concentration increase of the third element is in the range from 0.1 percentage point and 9 percentage points.

3. The light-emitting device of claim 1 or 2, wherein, in each of said three second layers (60), in any portion of the second layer having its height equal to 10% of the height of said portion of the active area (52) measured along a direction perpendicular to a surface of the substrate (34), the variation of the mass concentration of the third element between the ends, along said direction, of this portion is smaller than 50% of the variation of the mass concentration of the third element between the ends, along said direction, of said portion of the active area.

4. The light-emitting device of any of claims 1 to 3, wherein the mass concentration increase of the third element is linear.

5. The light-emitting device of any of claims 1 to 4, wherein each first layer (58) mainly comprises a III-V binary compound and each second layer (60) comprises the III-V compound wherein the III-type element is partly substituted with the third element.

6. The light-emitting device of any of claims 1 to 5, wherein the average mass concentration of said third element in the second layers (60) is in the range from 6% to 25%.

7. The light-emitting device of any of claims 1 to 6, wherein, for at least one of the semiconductor elements (40), the electrode (56) only partly covers the shell (48) covering said semiconductor element.

8. The light-emitting device of any of claims 1 to 7, wherein, for at least one of the semiconductor elements (40), the average external diameter of the active area (52) increases as the distance from the substrate (34) increases.

9. The light-emitting device of any of claims 1 to 8, wherein the semiconductor elements (40) are nanowires, microwires, and/or nanometer- or micrometer-range pyramidal structures.

10. A method of manufacturing a light-emitting device (30; 70; 90), comprising the steps of:
forming three-dimensional semiconductor elements (40) resting on a substrate (34);
forming, for each semiconductor element, at least one shell (48) at least partially covering the lateral walls of the semiconductor element, the shell comprising an active area (52) having multiple quantum wells; and
forming an electrode (56; 72) at least partially covering the shell (48), at least a portion (74) of the active layer (52) being sandwiched between the electrode and the lateral walls of the semiconductor element (40),
wherein the active area comprises an alternation of first semiconductor layers (58) mainly comprising a first element and a second element and of second semiconductor layers (60) mainly comprising the first element and the second element and further comprising a third element, **characterized in that**, in at least three of the second layers, the mass concentration of the third element increases in said portion of the active area as the distance to the substrate decreases.

11. The method of claim 10, comprising, for at least one of the semiconductor elements (40), on forming of said at least three second layers (60), maintaining a temperature gradient between the end of the semiconductor element most distant from the substrate (34) and the end of the semiconductor element closest to the substrate.

12. The method of claim 11, comprising, for at least one of the semiconductor elements (40), before the forming of said at least three second layers (60), the forming of the semiconductor element or of a layer (50) covering the semiconductor element having a greater average external diameter at the end of the semiconductor element most distant from the substrate than at the end of the semiconductor element closest to the substrate.
